Europäisches Patentamt

European Patent Office

Office européen des brevets

(11) Publication number: **0 115 131 B1**

# EUROPEAN PATENT SPECIFICATION

(45) Date of publication of patent specification: **13.09.89**

(21) Application number: **83307327.3**

(22) Date of filing: **01.12.83**

(51) Int. Cl.⁴: **H 01 L 21/76, H 01 L 29/78, H 01 L 29/60**

(54) MIS transistor having a deposited and buried isolation and method for manufacturing the same.

(30) Priority: **28.12.82 JP 233419/82**

(43) Date of publication of application:
**08.08.84 Bulletin 84/32**

(45) Publication of the grant of the patent:
**13.09.89 Bulletin 89/37**

(84) Designated Contracting States:
**DE FR GB**

(73) Proprietor: **KABUSHIKI KAISHA TOSHIBA
72, Horikawa-cho Saiwai-ku
Kawasaki-shi Kanagawa-ken 210 (JP)**

(72) Inventor: **Horiguchi, Fumio
3-26-3, Itabashi Itabashi-ku
Tokyo (JP)**

(74) Representative: **Freed, Arthur Woolf et al
MARKS & CLERK 57-60 Lincoln's Inn Fields
London WC2A 3LS (GB)**

(56) References cited:
EP-A-0 025 129
EP-A-0 062 170
EP-A-0 062 722
EP-A-0 074 541
EP-A-0 090 520
US-A-4 069 577

INTERNATIONAL ELECTRON DEVICES
MEETING, TECHNICAL DIGEST, Washington,
D.C., US, 7th-9th December 1981, pages 380-
383, IEEE, New York, US; T. IIZUKA et al.:
"Double threshold MOSFETS in bird's-beak free
structures"

(56) References cited:
IBM TECHNICAL DISCLOSURE BULLETIN, vol.
21, no. 7, December 1978, pages 2734-2737,
New York, US; H.B. POGGE: "Single mask
self-aligned trench isolation/diffusion process"

IBM TECHNICAL DISCLOSURE BULLETIN, vol.
21, no. 5, October 1978, pages 1868,1869, New
York, US; T.A. BARTUSH et al.: "Dielectric
isolation planarization"

## Description

This invention relates to a method of forming a MIS transistor having a deposited and buried isolation.

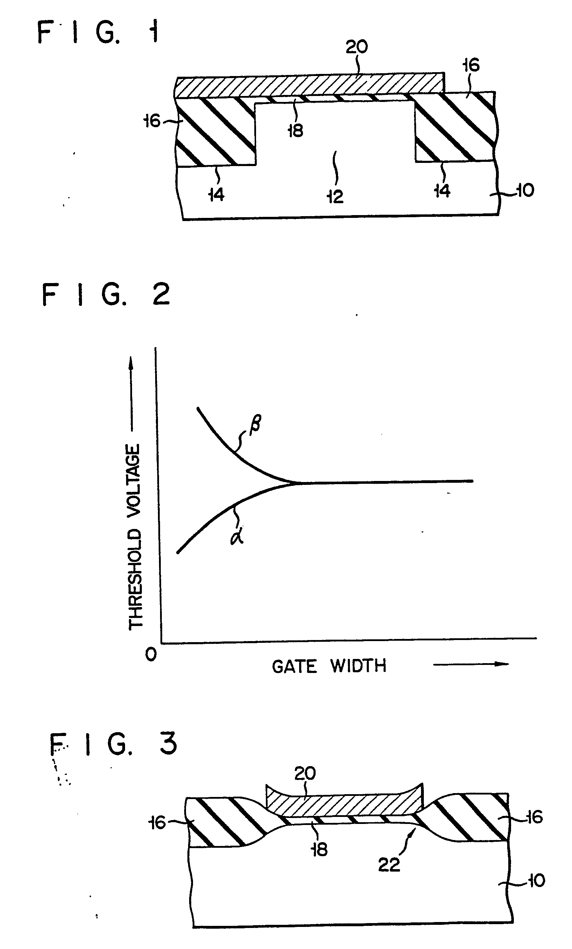

Japanese Patent Disclosure (KOKAI) No. 57-170547 discloses a MIS transistor having a deposited and buried isolation. As shown in Fig. 1, such a MIS transistor comprises: a semiconductor substrate 10 with an element forming region 12 formed therein; an insulating film 16 for isolating a device which is deposited and buried in a recessed portion 14 surrounding said device forming region 12; a gate insulating film 18; and a gate electrode 20. The gate electrode 20 is located on the insulating film 16 for isolating a device and has a gate fringe portion. In the case wherein the MIS transistor is miniaturized, for example; when the gate width becomes 1.0 µm or less, the inverse narrow channel effect indicated by curve α of Fig. 2 occurs. Due to this occurrence, a phenomenon wherein there is a reduced threshold voltage VT may be observed, so that the threshold voltage VT cannot be suitably controlled.

Furthermore, the existence of the gate fringe portion will also interfere with an increase in the integration density of the device. In view of the above, U.S.P. No. 4,160,987 and Japanese Patent Publication No. 57-1145 disclose FETs with nonoverlapping gates. However, the device isolation insulating film 14 of U.S.P. No. 4,160,987 is different from the present invention, since it is formed by thermal oxidization. When the device isolation insulating film 14 is formed by thermal oxidization, a bird's beak 22, such as that shown in Fig. 3, is formed. Thus, the narrow channel effect shown by the curve β of Fig. 2 occurs. The present invention is intended to eliminate the inverse narrow channel effect, as indicated by the curve α of Fig. 2.

An object of this invention is to provide a method of manufacturing a MIS transistor in which no fluctuation of the threshold voltage occurs as a result of a decrease in the gate width.

According to the invention, there is provided a method for manufacturing a MIS transistor having a deposited and buried isolation, comprising the steps of (a) etching a semiconductor substrate and forming a recessed portion in said semiconductor substrate, thereby forming an element forming region in the semiconductor substrate, said recessed portion being formed around said element forming region, (b) depositing an insulating material on said recessed portion, by the CVD method, thereby forming an insulating film for isolating elements, (c) forming a gate insulating film and a gate electrode on said element forming region, while forming source and drain regions within said element forming region, and (d) forming wiring configurations to be connected to said gate electrode, source and drain regions, characterised in that said step (a) comprises the steps of forming a first insulating film on said semiconductor substrate, forming a first conductive layer on said first insulating film, and sequentially etching said first conductive layer, said first insulating film and said semiconductor substrate, to form a first conductive layer pattern, a first insulating film pattern and the recessed portion in said semiconductor substrate, respectively, thereby forming the element forming region, in that said step (b) comprises the steps of forming a second insulating film on at least said recessed portion, by the CVD method, forming a third insulating film on said second insulating film and said element forming region, thereby making the surface flat, and sequentially etching said third insulating film and second second insulating film, to expose said first conductive layer pattern, thereby forming the insulating film conditions wherein the etching rates of said second and third insulating films are almost equal, and in that said step (c) comprises the step of etching said first conductive layer pattern and said first insulating film pattern, to form the gate electrode and gate insulating film, thereby forming the source and drain regions.

If a MIS transistor is formed as described above, the gate electrode can be self-aligned with the element forming region. Therefore, even when no gate fringe is provided, the gate electrode can be completely bridged between the source and drain.

An MIS transistor formed in accordance with a described embodiment of the above method has a deposited and buried isolation, which comprises a semiconductor substrate, an element forming region formed on the semiconductor substrate, said element forming region having a source region, drain region and channel region, an insulating film deposited on and buried within the semiconductor substrate, to surround the element forming region, a gate insulating film formed on the channel region, and a gate electrode formed on the gate insulating film, said gate electrode existing only on the element forming region, the edge portion in the direction of the channel width of the gate electrode being substantially aligned with the edge of the element forming region.

With a construction such as that mentioned above, the concentration of the electric fields at the corners of the element forming region is eliminated, so that the inverse narrow channel effect can be prevented. Therefore, the change in the threshold voltage Vt which results from a gate width can be eliminated.

In addition, since no gate electrode exists in an element isolating region, the area of the gate electrode is reduced, causing the stray capacitance to be reduced. The reduction of the stray capacitance allows the switching time to be shortened, thereby enabling a high-speed operation. Furthermore, it is possible to prevent the formation of a weak inversion layer in the semiconductor substrate under the element isolation film. Thus, the cause of the leak current can be eliminated.

Moreover, since no gate electrode exists on the element isolating region, there is no need for a gap to prevent the contact between the gate electrodes of the adjacent transistors. As a result, the limitation given to the pattern design by the gate electrode is eliminated, which allows the device to be highly integrated.

Other objects and advantages may be understood from the following description, taken in conjunction with the accompanying drawings, in which:

Fig. 1 is a cross-sectional view of a conventional MIS transistor;

Fig. 2 is a diagram showing the relationship between a gate width and a threshold voltage in a conventional MIS transistor;

Fig. 3 is a cross-sectional view of a conventional MIS transistor having an insulating film for isolating elements which is formed by thermal oxidization;

Fig. 4 is a plan view of a MIS transistor;

Fig. 5 is a cross-sectional view taken along line V-V of Fig. 4;

Fig. 6 is a cross-sectional view taken along line VI-VI of Fig. 4;

Fig. 7 is a cross-sectional view showing a modification of a MIS transistor;

Fig. 8 is a circuit diagram of a dynamic memory using a MIS transistor;

Fig. 9 is a diagram showing the relationship between a drain current $I_D$ and a gate voltage $V_G$ of the dynamic memory of Fig. 8;

Figs. 10A to 10K and Figs. 11A to 11K are cross-sectional views which are used to describe an embodiment of a method for manufacturing a MIS transistor according to the present invention;

Figs. 12A to 12E are cross-sectional views which are used to describe another embodiment of a method of manufacturing a MIS transistor according to the present invention; and

Figs. 13A to 13G are cross-sectional views used to describe yet another embodiment of a method of manufacturing a MIS transistor according to the present invention.

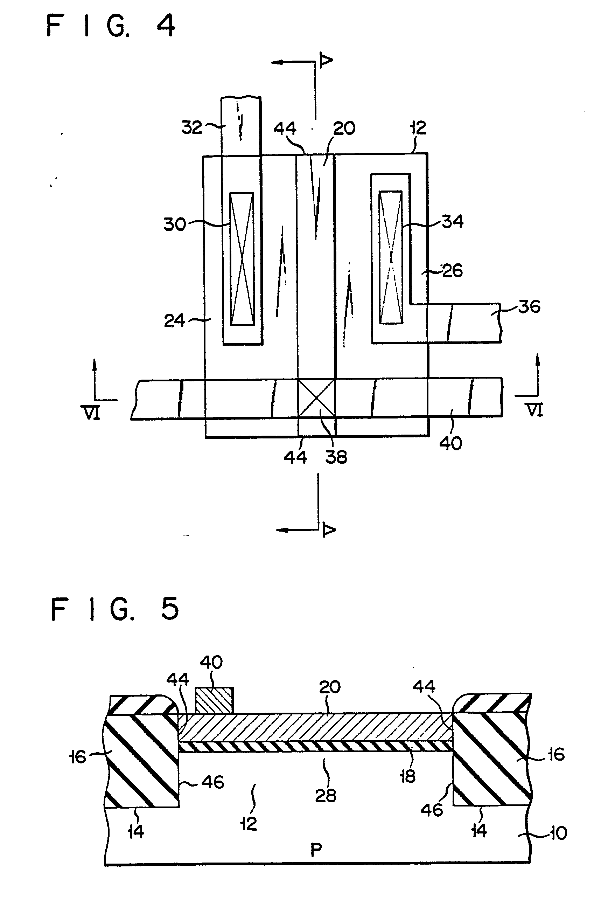

An MIS transistor may be described as follows, with reference to Figs. 4 to 6. A P-type semiconductor substrate 10 comprises an element forming region 12 and a recessed portion 14 surrounding the element forming region 12. The recessed portion 14 is formed by etching the semiconductor substrate 10. A CVD $SiO_2$ film 16 as an element isolation film is deposited in the recessed portion 14. Since the element isolation film is not formed by the thermally oxidization, no bird's beak will occur. $N^+$-type source and drain regions 24 and 26 are formed in the element forming region 12. The p-type semiconductor substrate 10 sandwiched by the source and drain regions 24, 26 becomes a channel region 28. A gate insulating film 18 is formed on the channel region 28, with a gate electrode 20 being formed on the gate insulating film 18. The source region 24 is connected to a wiring configuration 32, via a contact hole 30, and the drain region 26 is connected to another wiring configuration 36, via another contact hole 34. The gate electrode 20 is connected to a wiring configuration 40 via a contact 38. This wiring configuration 40 and the source and drain regions 24, 26 are electrically insulated by an $SiO_2$ insulating film 42.

As may be seen from Figs. 4 and 5, the gate electrode 20 exists only on the element forming region 12. An edge portion 44 in the direction of a channel width of the gate electrode is substantially aligned with an edge portion 46 of the element forming region.

With a construction such as that described above, the concentration of electric fields at the edge portion 46 of the element forming region 12 is eliminated, so that an inverse narrow channel effect will not appear. Therefore, a threshold voltage Vt will not fluctuate in dependence upon a gate width.

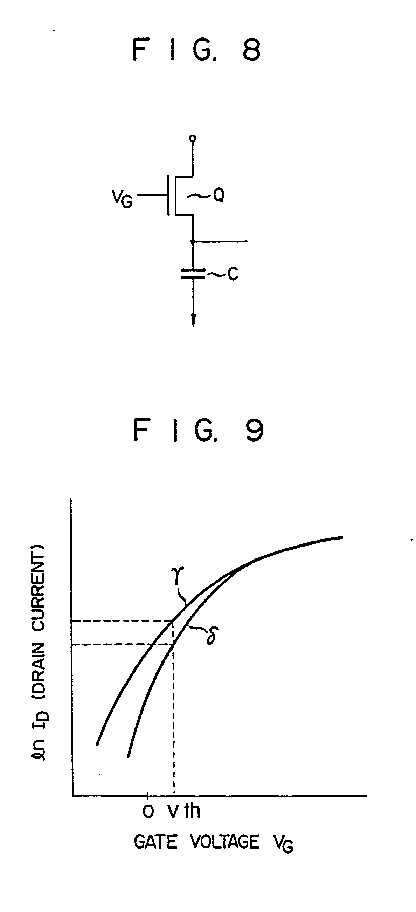

Let us now assume that a dynamic memory, such as that shown in Fig. 8, is constituted by using a MIS transistor 0 and a capacitor C. Thus, when the memory size is reduced and the channel width attains a size not larger than 1 μ, an inverse narrow channel effect occurs, in the case of a conventional MIS transistor, so that a $V_G$-$I_D$ characteristic such as that shown by the curve γ of Fig. 9 is obtained. In Fig. 9, reference character $V_G$ denotes a voltage to be applied to the gate of the MIS transistor, and $I_D$ represents a drain current flowing through the MIS transistor. The curve δ of Fig. 9 indicates the $V_G$-$I_D$ characteristic when no inverse narrow channel effect occurs. As may be seen from these curves, when the inverse narrow channel effect occurs, the drain current increases and the charge hold time of the dynamic memory is shortened. Therefore, the off characteristic will deteriorate. It is possible to prevent the above-mentioned charge hole time from deteriorating.

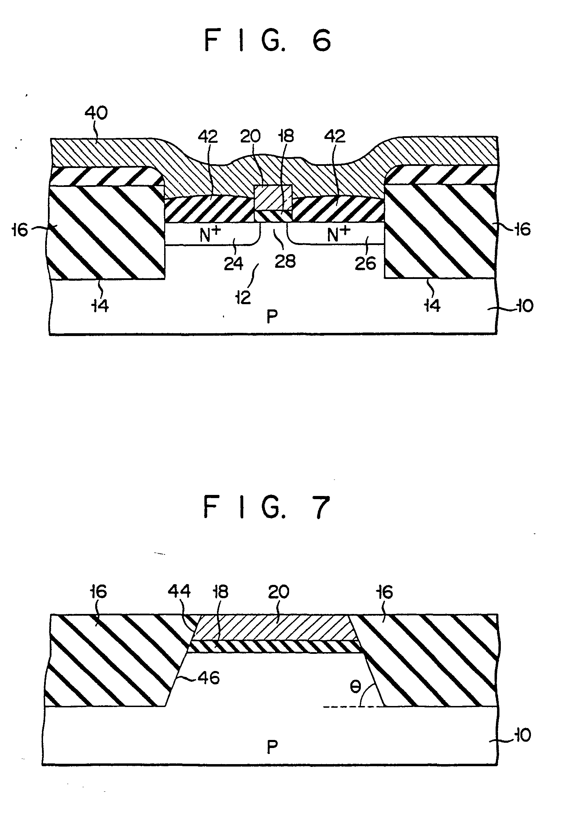

If the slope θ of the wall surface 46 in the direction of the channel width of the element forming region 12 coincides with the slope θ of the wall surface 44 in the direction of the channel width of the gate electrode 20, the inverse narrow channel effect can be effectively eliminated. preferably, the above-mentioned slope θ should not be smaller than 45° and not larger than 90°, as shown in Fig. 7.

A considerable inverse narrow channel effect occurs when the channel width is not larger than 1.0 μ. Therefore, when the present invention is applied to a device whose channel width is not larger than 1.0 μ, a considerable benefit to be derived will consist of the elimination of such an inverse narrow channel effect.

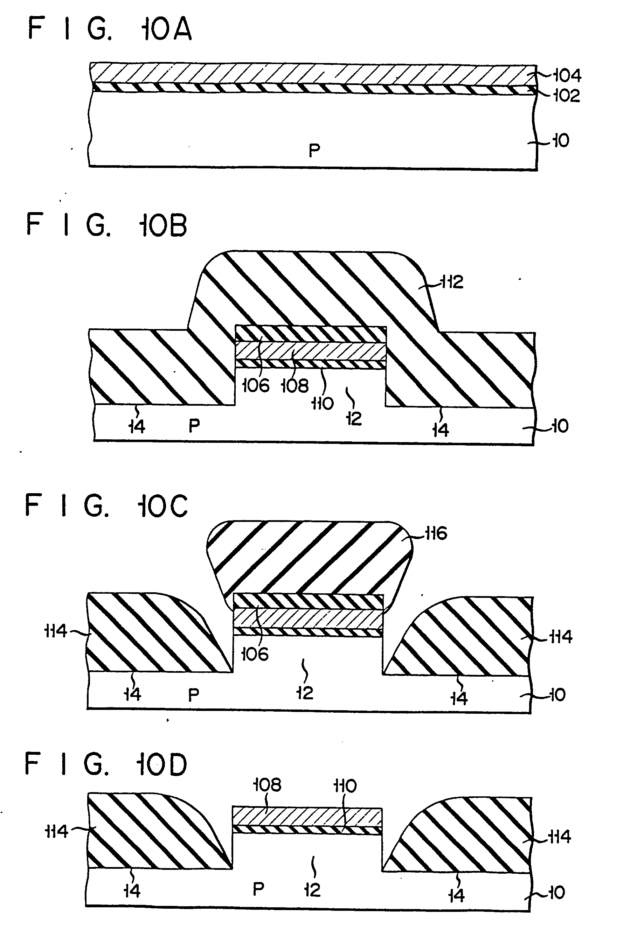

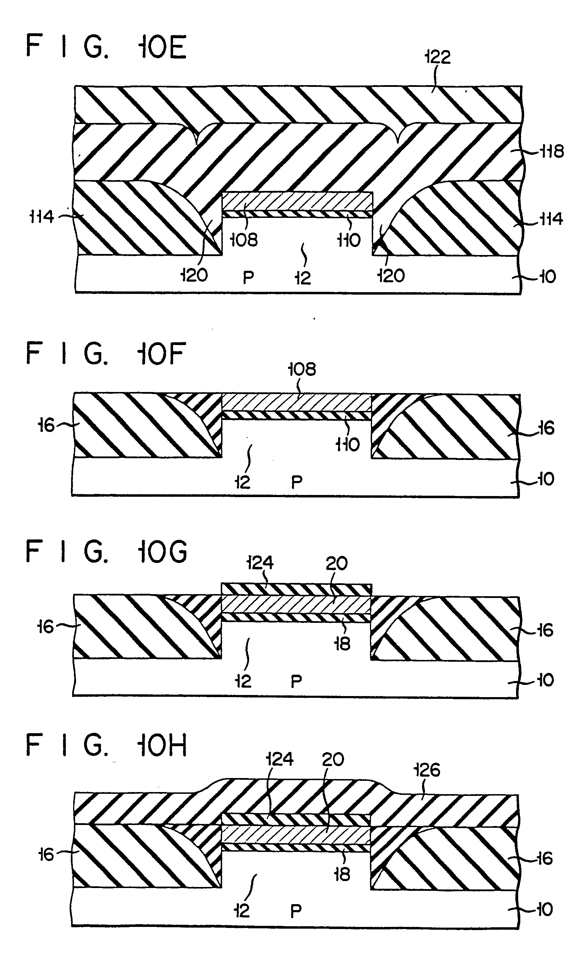

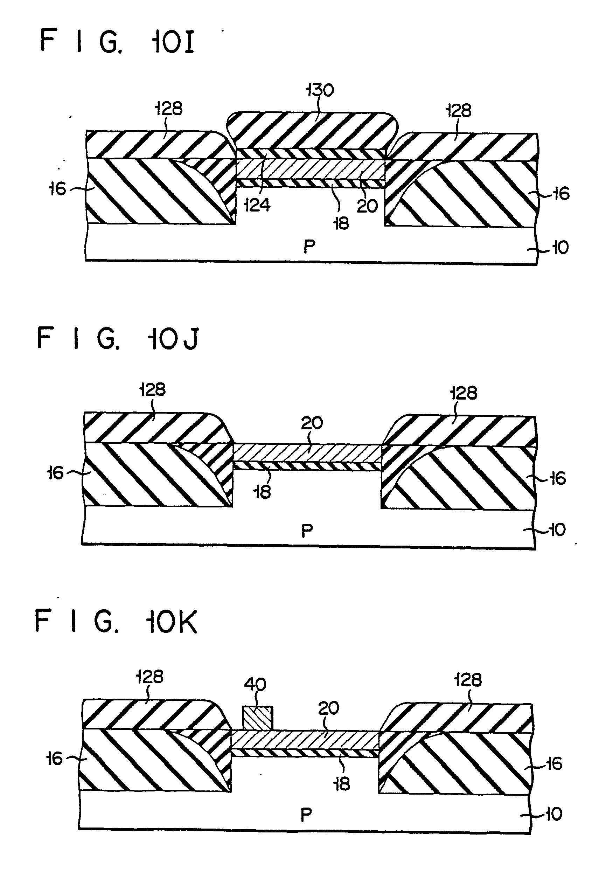

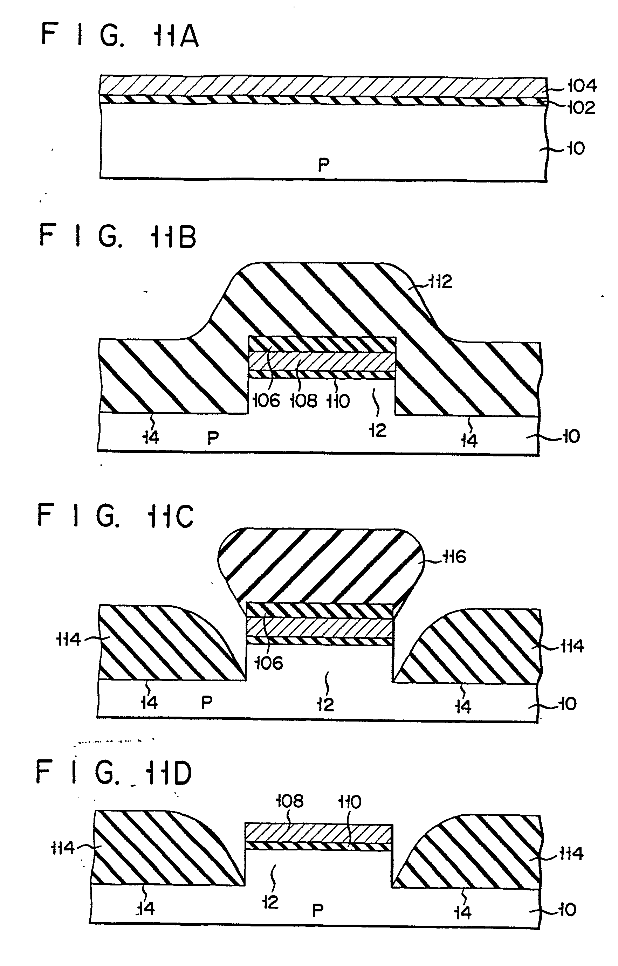

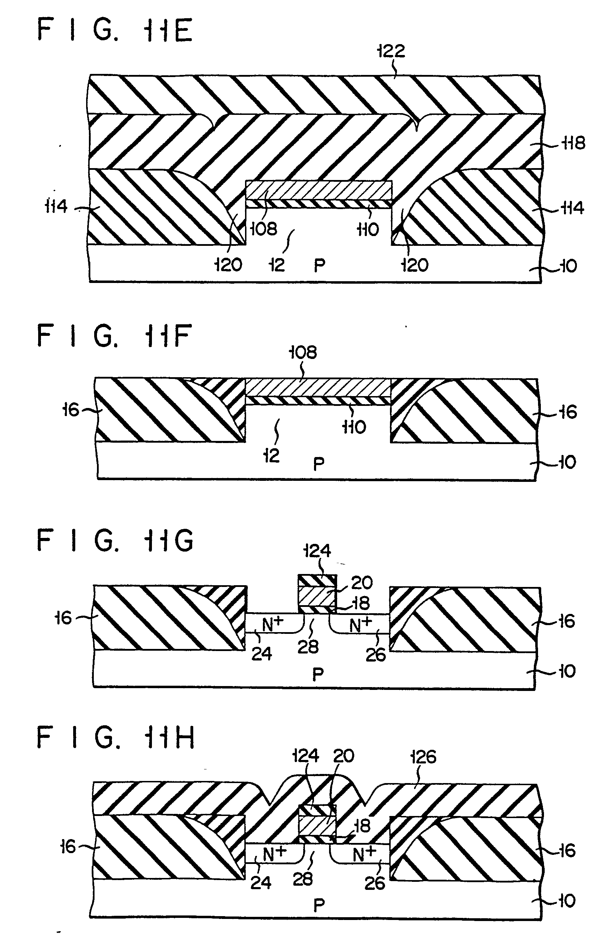

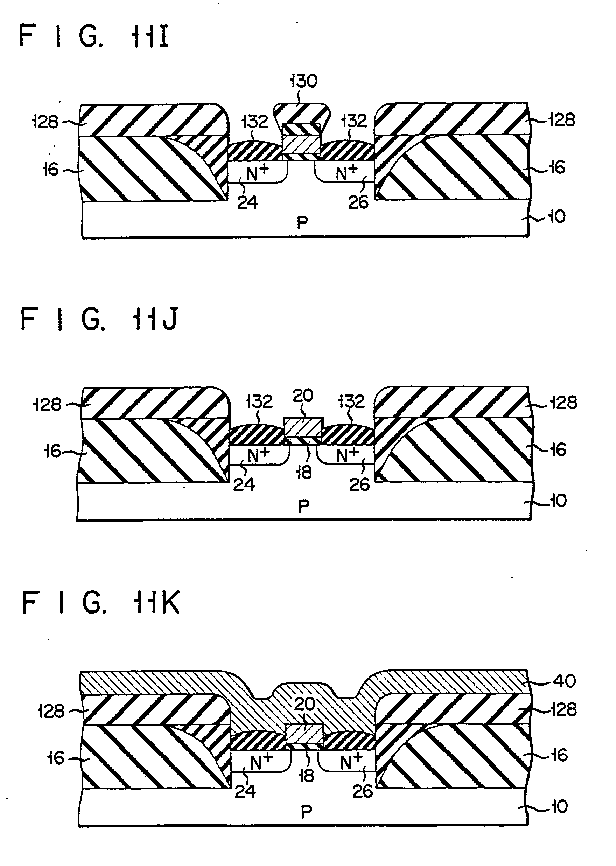

A first embodiment of a method of manufacturing a MIS transistor according to the present invention may be described with reference to Figs. 10A to 10K and Figs. 11A to 11K. Figs, 10A to 10K correspond to a cross-sectional view in the direction of line V-V of Fig. 4, and Figs. 11A to 11K correspond to a crosssectional view in the direction of line VI-VI of Fig. 4. As shown in Figs. 10A and 11A, a P-type silicon substrate 10 is prepared whose crystal plane is (1, 0, 0) and which has a specific resistance of 5 to 50 Ωcm. After the impurities for adjustment of the threshold voltage Vt are introduced in this silicon substrate 10, an oxide film 102 is formed over the whole surface on the substrate 10, and a polysilicon film 104 is further deposited on the oxide film 102. Next, as shown in Figs. 10B and 11B, a resist film is formed over the whole surface and this resist film is patterend to form a resist film pattern 106. The polysilicon film 104, oxide film 102 and silicon substrate 10 are etched, by using the resist film pattern 106 as a mask, thereby forming a polysilicon pattern 108, an oxide film pattern 110, the element forming region 12 and the recessed portion 14. Next, an $SiO_2$ film 112 is deposited over the entire surface by the plasma CVD method. Thereafter, the $SiO_2$ film 112 is etched by, e.g., an ammonium fluoride solution. Since the etching rate on the stepped portion of the $SiO_2$ film 112 is one digit larger than the etching rate on the flat portion of the $SiO_2$ film 112, as shown in Figs. 10C and llC, the $SiO_2$ film 112 is separated into an $SiO_2$ film 114 in the recessed portion and an $SiO_2$ film 116 on the element forming region 12. Thereafter the $SiO_2$ film 116 is removed by the lift-off method. That is, the resist film pattern 106 is removed by a mixed solution of, e.g., sulfuric acid and hydrogen peroxide, and the $SiO_2$ film 116 is also removed in the same manner (Figs. 10D and 11D). Next, as shown in Figs. 10E and 11E, an $SiO_2$ film 118 is deposited over the entire surface by the CVD method, thereby completely burying a V-shaped groove 120 by the $SiO_2$ film 118. A resist film 122 having a fluidity is further formed on it, thereby making the surface flat. Then, reactive ion etching, for example, is carried out over the entire surface. This reactive ion etching is executed under condition wherein the etching rates of the resist film 122 and $SiO_2$ film 118 are equal, being determined by suitably selecting the thermal treatment time of the resist film 122. Reactive ion etching is performed until the polysilicon pattern 108 is exposed (Figs. 10F and 11F), so that the element isolation film 16 may be formed. Next, a silicon nitride film is formed over the entire surface and is patterned, thereby forming a silicon nitride film pattern 124. The polysilicon pattern 108 and oxide film pattern 110 are etched by using the silicon nitride film pattern 124 as a mask, to form the gate electrode 20 and the gate insulating film 18. N-type impurities are introduced, to form the source and drain regions 24, 26 as well as the channel region 28 (Figs. 10G and 11G). Then, as shown in Figs. 10H and llH, an $SiO_2$ film 126 is deposited over the entire surface by the CVD method. The $SiO_2$ film 126 at the stepped portion is removed by slightly etching the whole surface using hydrogen fluoride HF, so that it is separated into an $SiO_2$ film 128 on the element isolation film 16, an $SiO_2$ film 130 on the silicon nitride film pattern 124, and an $SiO_2$ film 132 on the source and drain regions. Next, the silicon nitride film pattern 124 is etched, thereby removing the $SiO_2$ film 130 (Figs. 10J and 11J), Then, the entire surface is mildly etched by hydrogen fluoride and Al is deposited and patterned, to form the gate wiring 40.

Additionally, the source and drain wirings 32, 36 to be connected to the source and drain regions 24 and 26 are also formed (not shown).

An Al film may be used in place of the resist film pattern 106, to form the element forming region 12, Furthermore, it is also possible to employ various other methods which is disclosed in Japanese Patent Disclosure (KOKAI) No. 57-170547.

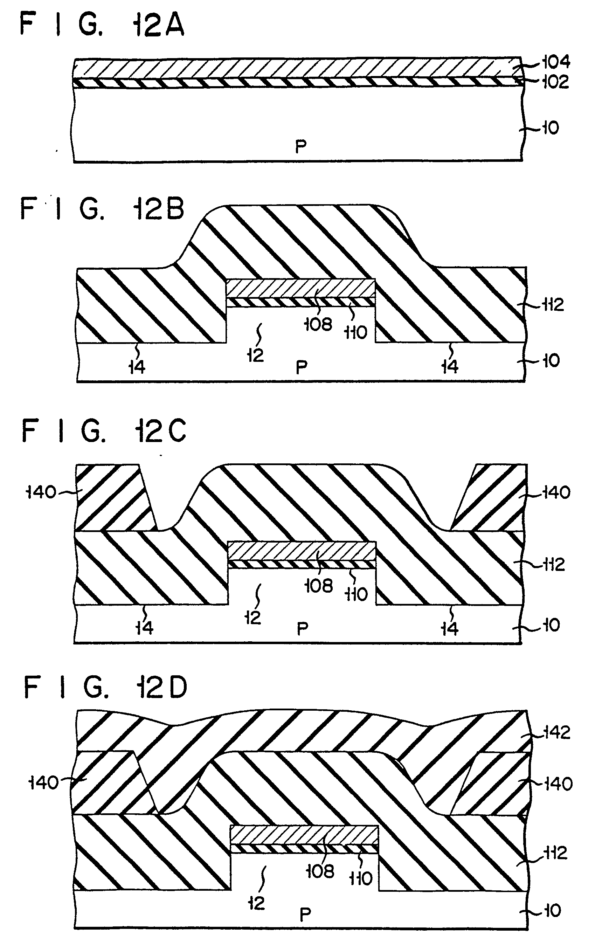

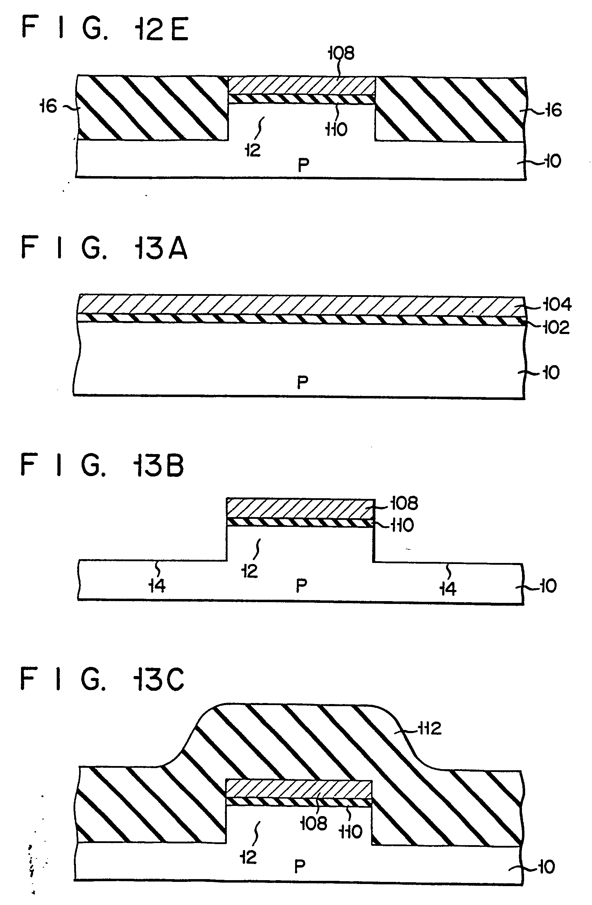

A second embodiment of the method of manufacturing a MIS transistor according to the present invention may be described with reference to Figs. 12A to 12E. As shown in Fig. 12A, after impurities for adjustment of the threshold voltage Vt are introduced to the P-type silicon substrate 10, an oxide film 102 is formed over the entire surface of the substrate 10, and a polysilicon film 104 is further deposited on the oxide film 102. A resist film is formed on the polysilicon film 104, being patterned in such a way as to form a mask. The polysilicon film 104, oxide film 102 and silicon substrate 10 are etched by using the above-mentioned mask, thereby forming the polysilicon pattern 108, oxide film pattern 110, element forming region 12, and recessed portion 14. Next, after removing the above-mentioned resist mask, the $SiO_2$ film 112 is deposited over the entire surface by the plasma CVD method (Fig. 12B). Thereafter, a resist film is deposited over the entire surface, as shown in Fig. 12C, and is patterned in such a way as to remove only the resist film on the element forming region 12, thereby forming a resist film pattern 140. Furthermore, as shown in Fig. 12D, another resist film 142 is formed over the entire surface, thereby making the surface flat, The resist film pattern 140 and the resist film 142 consist of PMMA (polymethyl methacrylate) and OFPR (a trade name of the Tokyo Ooka Co., Ltd). A proper mixing ratio of the above two chemical components allows the etching rates of the resist films to coincide with the etching rate of the CVD-$SiO_2$ film 112. As shown in Fig. 12E, reactive dry etching may then be carried out under conditions wherein the etching rates of the $SiO_2$ film 112, resist film pattern 140 and resist film 142 are equal, thereby exposing the polysilicon pattern 108. In this way, the element isolation film 16 is formed, Since the subsequent steps are similar to those which have already been mentioned with reference to the first embodiment, a detailed description thereof is omitted.

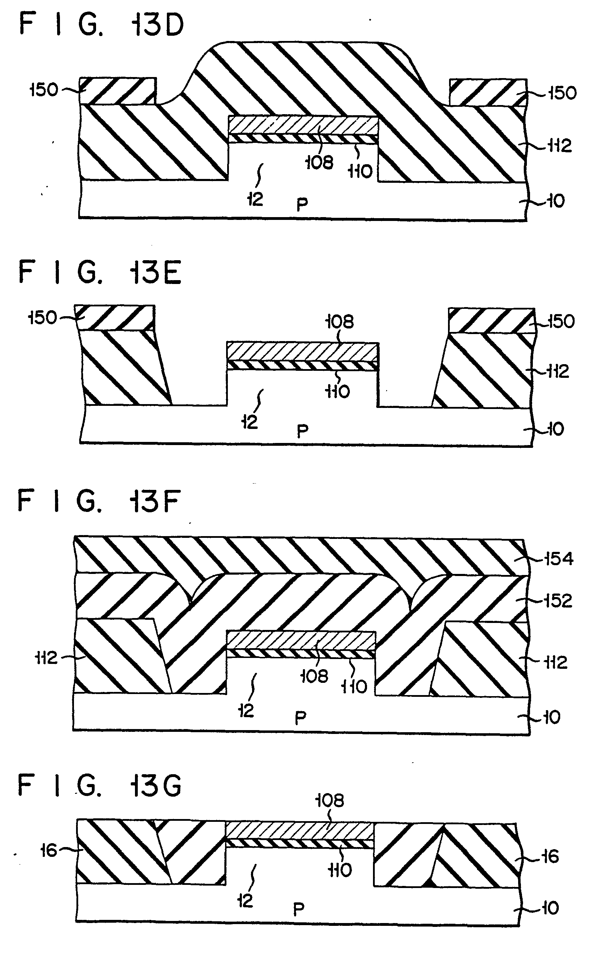

A third embodiment of a method of manufacturing a MIS transistor according to the present invention may be described with reference to Figs. 13A to 13G. As shown in Fig. 13A, after the impurities for adjustment of the threshold voltage Vt are introduced to the P-type silicon substrate 10, the oxide film 102 is formed over the entire surface of the substrate 10, and the polysilicon film 104 is further deposited on the oxide film 102. A resist film is formed on the polysilicon film 104 and is patterned in such a way as to form a mask. The polysilicon film 104, oxide film 102 and silicon substrate 10 are etched by using the abovementioned mask, to form the polysilicon pattern 108, oxide film pattern 110, element forming region 12 and recessed portion 14 (Fig. 13B). After the abovementioned resist mask was removed, the $SiO_2$ film 112 is deposited over the entire s'urface by the plasma CVD method (Fig. 13C), Thereafter, as shown in Fig. 13D, a resist film is deposited over the entire surface and only the resist film on the element forming region 12 is removed, to form a resist film pattern 150. By using the resist film pattern 150 as a mask, the $SiO_2$ film 112 on the element forming region 12 is selectively removed (Fig. 13E). After removing the resist film pattern 150, as shown in Fig. 13F, an $SiO_2$ film 152 is formed over the entire surface by the CVD method and a resist film 154 is further formed thereon, thereby making the surface flat. Next, as shown in Fig. 13G, reactive dry etching is performed under conditions wherein the etching rates of the $SiO_2$ films 112, 152 and the resist film 154 are equal, thereby exposing the polysilicon pattern 108. Thus, the element isolation film 16 is formed. Since the subsequent steps are similar to those which have already been mentioned with respect to the first embodiment; a detailed description thereof is omitted.

The present invention is not limited to the above-described embodiments. For example, the above-mentioned gate electrode material is not limited to a polysilicon, but may be a metal such as Al, or an alloy such as Mo-Si. In addition, just as the above-mentioned insulating film for isolating elements is not limited to a CVD-$SiO_2$ film; similarly, the gate insulating film is not limited to a thermally oxidized film. Moreover, many other modifications and variations are possible, without departing from the scope of the invention.

**Claims**

1. A method for manufacturing a MIS transistor having a deposited and buried isolation, comprising the steps of (a) etching a semiconductor substrate (10) and forming a recessed portion (14) in said semiconductor substrate, thereby forming an element forming region (12) in the semiconductor substrate, said recessed portion being formed around said element forming region, (b) depositing an insulating material on said recessed portion, by the CVD method, thereby forming an insulating film (16) for isolating elements, (c) forming a gate insulating film (18) and a gate electrode (20) on said element forming region, while forming source and drain regions (24, 26) within said element forming region, and (d) forming wiring configurations (32, 36, 38) to be connected to said gate electrode, source and drain regions, characterised in that said step (a) comprises the steps of forming a first insulating film (102) on said semiconductor substrate (10), forming a first conductive layer (104) on said first insulating film, and sequentially etching said first conductive layer, said first insulating film and said semiconductor substrate, to form a first conductive layer pattern (108), a first insulating film pattern (110) and the recessed portion (14) in said semiconductor substrate respectively, thereby forming the element forming region (12), in that said step (b) comprises the steps of forming a second insulating film (112, 118) on at least said recessed portion, by the CVD method, forming a third insulating film (118, 122, 142, 152, 154) on said second insulating film and said element forming region, thereby making the surface flat, and sequentially etching said third insulating film and second second insulating film, to expose said first conductive layer pattern (108), thereby forming the insulating film (16) for isolating an element, this step being executed under conditions wherein the etching rates of said second and third insulating films are almost equal, and in that said step (c) comprises the step of etching said first conductive layer pattern and said first insulating film pattern, to form the gate electrode (20) and gate insulating film (18), thereby forming the source and drain regions (24, 26).

2. A method according to claim 1, characterized in that said second insulating film is formed of $SiO_2$.

3. A method according to claim 1. characterized in that said step of forming the second insulating film comprises the sub-steps of:

forming the second insulating film (112) over the entire surface, by the CVD method;

etching said second insulating film around the element forming region, thereby separating the second insulating film (116) on the element forming region from the second insulating film (114) in the recessed portion; and

eliminating the second insulating film (116) on the element forming region, by the lift-off method, thereby exposing said first conductive layer pattern (108).

4. A method according to claim 3, characterized in that said step of forming the third insulating film comprises the sub-steps of:

forming a fourth insulating film (118) over the entire surface, by the CVD method; and

providing a resist layer (122) on said fourth insulating film, thereby making the surface flat.

5. A method according to claim 1. characterized in that said step of forming the second insulating film comprises the sub-steps of:

forming the second insulating film (112) over the entire surface, by the CVD method;

forming a mask (150) on said second insulating film on the recessed portion;

eliminating the second insulating film (112) around said element forming region and on said first conductive layer pattern; and

eliminating said mask (150).

6. A method according to claim 5, characterized in that said step of forming the third insulating film comprises the sub-steps of:

forming a fourth insulating film (152) over the entire surface, by the CVD method; and

providing a resist layer (154) on said fourth insulating film, thereby making the surface flat.

7. A method according to claim 1, characterized in that said step of forming the second insulting film comprises the sub-step of:

forming the second insulating film (112) over the entire surface, by the CVD method.

8. A method according to claim 7, characterized in that said step of forming the third insulating film comprises the sub-steps of:

providing a first resist layer (140) on said second insulating film on the recessed portion; and

forming the second resist layer (142) over the entire surface, thereby making the surface flat.

**Patentansprüche**

1. Verfahren zur Herstellung eines MIS-Transistors mit einer abgelagerten und vergrabenen Isolation, umfassend die folgenden Schritte: (a) Ätzen eines Halbleitersubstrats (10) und Ausbilden eines ausgesparten Abschnitts (14) im Halbleitersubstrat zwecks Ausbildung eines Elementerzeugungsbereichs (12) im Halbleitersubstrat, wobei der ausgesparte Abschnitt um den Elementerzeugungsbereich herum geformt ist, (b) Ablagern eines Isoliermaterials nach dem CVD-Verfahren auf dem ausgesparten Abschnitt zwecks Erzeugung eines Isolierfilms (16) für Isolierelemente, (c) Erzeugen eines Gateisolierfilms (18) und einer Gateelektrode (20) auf dem Elementerzeugungsbereich unter Ausbildung von Source- und Drainzonen (24, 26) im Elementerzeugungsbereich und (d) Erzeugen von mit Gateelektrode sowie Source- und Drainzonen zu verbindenden Verdrahtungsgebilden (32, 36, 38), dadurch gekennzeichnet, daß Schritt (a) die Schritte "Erzeugung eines ersten Isolierfilms (102) auf dem Halbleitersubstrat (10), Erzeugung einer ersten Leiterschicht (104) auf dem ersten Isolierfilm und anschließendes Ätzen der ersten Leiterschicht, des ersten Isolierfilms und des Halbleitersubstrats zwecks Ausbildung eines ersten Leiterschichtmusters (108), eines ersten Isolierfilmmusters (110) bzw. des ausgesparten Abschnitts (14) im Halbleitersubstrat" umfaßt, um damit den Elementerzeugungsbereich (12) auszubilden, daß Schritt (b) die Schritte "Erzeugung eines zweiten Isolierfilms (112, 118) nach dem CVD-Verfahren auf zumindest dem ausgesparten Abschnitt, Erzeugung eines dritten Isolierfilms (118, 122, 142, 152, 154) auf dem zweiten Isolierfilm und dem Elementerzeugungsbereich, um damit die Oberfläche flach auszubilden, und anschließendes Ätzen des dritten Isolierfilms sowie des zweiten Isolierfilms" zwecks Freilegung des ersten Leiterschichtmusters (108) unter Ausbildung des Isolierfilms (16) zum Isolieren eines Elements umfaßt, wobei dieser Schritt unter Bedingungen ausgeführt wird, bei denen die Ätzgeschwindigkeiten von zweitem und drittem Isolierfilm nahezu gleich sind, und daß Schritt (c) den Schritt "Ätzen des ersten Leiterschichtmusters und des ersten Isolierschichtmusters" zwecks Erzeugung der Gateelektrode (20) und des Gateisolierfilms (18) unter Ausbildung von Source- und Drainzonen (24, 26) umfaßt.

2. Verfahren nach Anspruch 1, dadurch gekennzeichnet, daß der zweite Isolierfilm aus $SiO_2$ gebildet wird.

3. Verfahren nach Anspruch 1, dadurch gekennzeichnet, daß der Schritt der Erzeugung des zweiten Isolierfilms folgende Unterschritte umfaßt:

Erzeugen des zweiten Isolierfilms (112) nach dem CVD-Verfahren auf der Gesamtoberfläche,

Ätzen des zweiten Isolierfilms um den Elementerzeugungsbereich herum zwecks Trennung des zweiten Isolierfilms (116) auf dem Elementerzeugungsbereich vom zweiten Isolierfilm (114) im ausgesparten Abschnitt und

Entfernen des zweiten Isolierfilms (116) vom Elementerzeugungsbereich nach der Abhebeoder Abziehmethode zwecks Freilegung des ersten Leiterschichtmusters (108).

4. Verfahren nach Anspruch 3, dadurch gekennzeichnet, daß der Schritt der Erzeugung des dritten Isolierfilms folgende Unterschritte umfaßt:

Erzeugen eines vierten Isolierfilms (118) nach dem CVD-Verfahren auf der Gesamtoberfläche und

Aufbringen einer Resistschicht (122) auf den vierten Isolierfilm, um damit die Oberfläche flach zu gestalten.

5. Verfahren nach Anspruch 1, dadurch gekennzeichnet, daß der Schritt der Erzeugung des zweiten Isolierfilms die folgenden Unterschritte umfaßt:

Erzeugen des zweiten Isolierfilms (112) nach dem CVD-Verfahren auf der Gesamtoberfläche,

Ausbilden einer Maske (150) auf dem auf dem ausgesparten Abschnitt befindlichen zweiten Isolierfilm,

Entfernen des zweiten Isolierfilms (112) um den Elementerzeugungsbereich herum und vom ersten Leiterschichtmuster und

Entfernen der Maske (150).

6. Verfahren nach Anspruch 5, dadurch gekennzeichnet, daß der Schritt der Erzeugung des dritten Isolierfilms folgende Unterschritte umfaßt:

Erzeugen eines vierten Isolierfilms (152) nach dem CVD-Verfahren auf der Gesamtoberfläche und

Aufbringen einer Resistschicht (154) auf den vierten Isolierfilm, um damit die Oberfläche flach zu gestalten.

7. Verfahren nach Anspruch 1, dadurch gekennzeichnet, daß der Schritt der Erzeugung des zweiten Isolierfilms folgenden Unterschritt umfaßt:

Erzeugen des zweiten Isolierfilms (112) nach dem CVD-Verfahren auf der Gesamtoberfläche.

8. Verfahren nach Anspruch 7, dadurch gekennzeichnet, daß der Schritt der Erzeugung des dritten Isolierfilms folgende Unterschritte umfaßt:

Aufbringen einer ersten Resistschicht (140) auf den auf dem ausgesparten Abschnitt befindlichen zweiten Isolierfilm und

Erzeugen einer zweiten Resistschicht (142) auf der Gesamtoberfläche, um damit die Oberfläche flach zu gestalten.

**Revendications**

1. Procédé de fabrication d'un transistor MIS comportant une isolation déposée et enterrée, qui comprend les opérations suivantes: (a) graver un substrat semiconducteur (10) et former une partie évidée (14) dans ledit substrat semiconducteur, si bien qu'on forme une région de formation d'éléments (12) dans le substrat semiconducteur, ladite partie évidée étant formée autour de ladite région de formation d'éléments, (b) déposer un matériau isolant sur ladite partie évidée, par le procédé CVD, si bien qu'on forme une pellicule isolante (16) servant à isoler des éléments, (c) former une pellicule isolante de grille (18) et une électrode de grille (20) sur ladite région de formation d'éléments, tout en formant des régions de source et de drain (24, 26) à l'intérieur de ladite région de formation d'éléments, et (d) former des configurations de câblage (32, 36, 38) destinées à être connectées à ladite électrode de grille et aux régions de source et de drain, caractérise en ce que ladite opération (a) comprend les opérations consistant à former une première pellicule isolante (102) sur ledit substrat semiconducteur (10), à former une première couche conductrice (104) sur ladite première pellicule isolante, et à séquentiellement graver ladite première couche conductrice, ladite première pellicule isolante et ledit substrat semiconducteur, afin de former respectivement une configuration de première couche conductrice (108), une configuration de première pellicule isolante (110) et la partie évidée, (14) dans ledit substrat semiconducteur, si bien qu'on forme la région de formation d'éléments (12), en ce que ladite opération (b) comprend les opérations consistant à former une deuxième pellicule isolante (112, 118) au moins sur ladite partie évidée, par le procédé CVD, à former une troisième pellicule isolante (118, 122, 142, 152, 154) sur ladite deuxième pellicule isolante et ladite région de formation d'éléments, si bien qu'on rend la surface plane, et à séquentiellement graver ladite troisième pellicule isolante et ladite deuxième pellicule isolante afin d'exposer ladite configuration de première couche conductrice (108), si bien qu'on forme la pellicule isolante (16) servant à isoler un élément, cette opération étant exécutée dans des conditions où les vitesses de gravure desdites deuxième et troisième pellicules isolantes sont presque égales, et en ce que ladite opération (c) comprend l'opération consistant à graver ladite configuration de première couche conductrice et ladite configuration de première pellicule isolante, de manière à former l'électrode de grille (20) et la pellicule isolante de grille (18), si bien qu'on forme les régions de source et de drain (24, 26).

2. Procédé selon la revendication 1, caractérisé en ce que ladite deuxième pellicule isolante est formée de SiO₂.

3. Procédé selon la revendication 1, caractérisé en ce que ladite opération de formation de ladite deuxième pellicule isolante comprend les sous-opérations suivantes:
former la deuxième pellicule isolante (112) sur toute la surface, par le procédé CVD;
graver ladite deuxième pellicule isolante se trouvant autour de la région de formation d'éléments, si bien qu'on sépare la deuxième pellicule isolante (116) se trouvant sur la région de formation d'éléments vis-à-vis de la deuxième pellicule isolante (114) se trouvant dans la partie évidée; et
éliminer la deuxième pellicule isolante (116) se trouvant sur la région de formation d'éléments, par le procédé de décollement, si bien qu'on expose ladite configuration de première couche conductrice (108).

4. Procédé selon la revendication 3, caractérisé en ce que ladite opération de formation de la troisième pellicule isolante comprend les sous-opérations suivantes:
former une quatrième pellicule isolante (118) sur toute la surface, par le procédé CVD; et
produire une couche d'agent sensible de type réserve (122) sur la quatrième pellicule isolante, si bien qu'on rend la surface plane.

5. Procédé selon la revendication 1, caractérisé en ce que ladite opération de formation de la deuxième pellicule isolante comprend les sous-opérations suivantes:
former la deuxième pellicule isolante (112) sur toute la surface, par le procédé CVD;
former un masque (150) sur la deuxième pellicule d'isolation se trouvant sur la partie évidée;
éliminer la deuxième pellicule isolante (112) se trouvant autour de ladite région de formation d'éléments et sur ladite configuration de première couche conductrice; et
éliminer ledit masque (150).

6. Procédé selon la revendication 5, caractérisé en ce que ladite opération de formation de la troisième pellicule isolante comprend les sous-opérations suivantes:
former une quatrième pellicule isolante (152) sur toute la surface, par le procédé CVD; et
produire une couche d'agent sensible de type réserve (154) sur ladite quatrième pellicule isolante, si bien qu'on rend la surface plane.

7. Procédé selon la revendication 1, caractérisé en ce que ladite opération de formation de la deuxième pellicule isolante comprend la sous-opérations suivante:
former la deuxième pellicule isolante (112) sur toute la surface, par le procédé CVD.

8. Procédé selon la revendication 7, caractérisé en ce que ladite opération de formation de la troisième pellicule isolante comprend les sous-opérations suivantes:
produire une première couche d'agent sensible de type réserve (140) sur ladite deuxième pellicule isolante se trouvant sur la partie évidée; et
former la deuxième couche d'agent sensible de type réserve (142) sur toute la surface, de manière à rendre la surface plane.

F I G. 1

F I G. 2

THRESHOLD VOLTAGE

$\beta$

$\alpha$

0          GATE   WIDTH

F I G. 3

F I G. 4

F I G. 5

# F I G. 6

# F I G. 7

# F I G. 8

# F I G. 9

F I G. 10A

104
102

P

10

F I G. 10B

112

106 108
110
12

14 P 14 10

F I G. 10C

116

114
106
114

14 P 12 14 10

F I G. 10D

108 110

114
114

14 P 12 14 10

# F I G. 10E

# F I G. 10F

# F I G. 10G

# F I G. 10H

F I G. 10I

F I G. 10J

F I G. 10K

F I G. 11A

104
102

10

P

F I G. 11B

112

106 108 110

12

14    P    14    10

F I G. 11C

116

114

106

114

14    P    12    14    10

F I G. 11D

108    110

114

114

14    12    P    14    10

# F I G. 11E

# F I G. 11F

# F I G. 11G

# F I G. 11H

**EP 0 115 131 B1**

# F I G. 11I

# F I G. 11J

# F I G. 11K

10

# F I G. 12A

104
102
10
P

# F I G. 12B

112
108   110
14   12   14
P   10

# F I G. 12C

140   140
112
108   110
140   14   12   14   10
P

# F I G. 12D

142
140   140
112
108   110
12   10
P

# F I G. 12E

108

16 ~        110
12
P        16
10

# F I G. 13A

104
102
P        10

# F I G. 13B

108
110
12
14        P        14        10

# F I G. 13C

112

108 110
12        P        10

# F I G. 13D

150 ~

108  110

12  P

150

112

10

# F I G. 13E

150 ~

108

110

12  P

150

112

10

# F I G. 13F

112 ~

108  110

12  P

154

152

112

10

# F I G. 13G

108

16 ~

110

12  P

16

10